# EUROPEAN PATENT APPLICATION

(11) **EP 4 770 392 A1**
(43) Date of publication of application: **01.07.2026**
(21) Application number: 24954585.6
(22) Date of filing: 02.04.2024
(51) Int. Cl.: H10K 59/50

(54) **DISPLAY PANEL AND DISPLAY DEVICE**

(30) Priority: 28.03.2024 CN 202410371303
(71) Applicant: Wuhan China Star Optoelectronics Semiconductor Display Technology Co., Ltd., Wuhan, Hubei 430079 (CN)
(72) Inventor: QI, Fei, Wuhan, Hubei 430079 (CN)
(74) Representative: Studio Torta S.p.A.
(86) International application number: PCT/CN2024/085585
(87) International publication number: WO 2025/200038

(57) **Abstract**

Disclosed are a display panel and a display device. The display panel includes a light-emitting layer and an encapsulation layer disposed on a light-exiting side of the light-emitting layer. The encapsulation layer includes a first inorganic layer, and a first organic layer disposed on a side of the first inorganic layer away from the light-emitting layer. The first inorganic layer includes a first sub-layer and a second sub-layer disposed between the first sub-layer and the first organic layer. A refractive index of the first sub-layer is greater than that of the second sub-layer; and a thickness of the first sub-layer is less than that of the second sub-layer.

## Description

### TECHNICAL FIELD

The present disclosure relates to the field of display, and more particularly, to a display panel and a display device.

### BACKGROUND

Organic light-emitting diode (OLED)-based products have advantages such as self-luminescence, wide color gamut, low power consumption, and flexible display, and thus are widely used. At present, the OLED display panel includes an encapsulation layer disposed on a light-exiting side of the pixel unit. The encapsulation layer includes an inorganic layer, an organic layer, and an inorganic layer which are stacked in sequence. The inorganic layer of the encapsulation layer is prepared by chemical vapor deposition, which may cause poor film-forming uniformity, resulting in significant non-uniformity in thickness of the inorganic layer at the central area and the surrounding area of the display panel, so that it brings out poor display such as large color difference.

Accordingly, there is a need for the display panel and the display device to solve the above technical problem.

### SUMMARY

The present disclosure provides a display panel and a display device, which can alleviate the poor display caused by non-uniformity in thickness of the inorganic layer of the encapsulation layer at the central area and the surrounding area.

To solve the above problem, the present disclosure provides the following technical solutions.

The present disclosure provides a display panel including:
a light-emitting layer; and
an encapsulation layer disposed on a light-exiting side of the light-emitting layer, in which the encapsulation layer includes a first inorganic layer and a first organic layer, and the first organic layer is disposed on a side of the first inorganic layer away from the light-emitting layer.

The first inorganic layer includes a first sub-layer and a second sub-layer, the second sub-layer is disposed between the first sub-layer and the first organic layer, and a refractive index of the first sub-layer is greater than that of the second sub-layer.

A thickness of the first sub-layer is less than that of the second sub-layer.

The present disclosure further provides a display device, including a display panel that includes:
a light-emitting layer; and
an encapsulation layer disposed on a light-exiting side of the light-emitting layer, wherein the encapsulation layer includes a first inorganic layer and a first organic layer, and the first organic layer is disposed on a side of the first inorganic layer away from the light-emitting layer.

The first inorganic layer includes a first sub-layer and a second sub-layer, the second sub-layer is disposed between the first sub-layer and the first organic layer, and a refractive index of the first sub-layer is greater than a refractive index of the second sub-layer.

A thickness of the first sub-layer is less than a thickness of the second sub-layer.

### BRIEF DESCRIPTION OF THE DRAWINGS

FIG. 1 is a schematic diagram of a first structure of a display panel according to some embodiments of the present disclosure.
FIG. 2 is a schematic diagram of a second structure of a display panel according to some embodiments of the present disclosure.
FIG. 3 is a schematic diagram of a third structure of a display panel according to some embodiments of the present disclosure.
FIG. 4 is a schematic diagram of a fourth structure of a display panel according to some embodiments of the present disclosure.
FIG. 5 is a schematic diagram of a display device according to some embodiments of the present disclosure.

### DETAILED DESCRIPTION OF EMBODIMENTS

The present disclosure provides a display panel and a display device. In order to make the objectives, technical solutions and effect(s) of the present disclosure clear and explicit, the present disclosure will be described in detail below with reference to the accompanying drawings and embodiments. It is to be understood that the specific embodiments described herein are merely illustrative of the present disclosure and are not intended to limit the present disclosure.

At present, the display panel in the related art has a significant non-uniformity in thickness of the inorganic layer of the encapsulation layer of the display panel at the central area and the surrounding area of the display panel, resulting in poor display such as lager color difference.

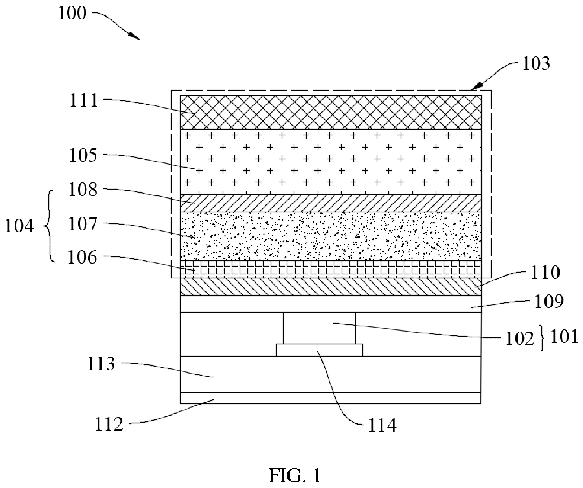

Referring to FIGs. 1 to 4, some embodiments of the present disclosure provide a display panel 100 including:
a light-emitting layer 101;
an encapsulation layer 103 disposed on a light-exiting side of the light-emitting layer 101, wherein the encapsulation layer 103 includes a first inorganic layer 104 and a first organic layer 105, and the first organic layer 105 is disposed on a side of the first inorganic layer 104 away from the light-emitting layer 101.

The first inorganic layer 104 includes a first sub-layer 106 and a second sub-layer 107. The second sub-layer 107 is disposed between the first sub-layer 106 and the first organic layer 105, and a refractive index of the first sub-layer 106 is greater than that of the second sub-layer 107.

The thickness of the first sub-layer is less than that of the second sub-layer.

According to the embodiments of the present disclosure, the light output efficiency of the display panel 100 is increased, and the display effect of the display panel 100 is improved, by providing the first sub-layer 106 and the second sub-layer 107 in the first inorganic layer 104 of the encapsulation layer 103 of the display panel 100, and setting the refractive indices of the first sub-layer 106 and the second sub-layer 107 to be reduced in sequence and the thickness of the first sub-layer 106 to be less than that of the second sub-layer 107.

The technical solutions of the present disclosure will now be described with reference to specific embodiments.

In some embodiments, an extinction coefficient of the second sub-layer 107 in the visible light range is less than or equal to an extinction coefficient of the first sub-layer 106 in the visible light range. Preferably, the extinction coefficient of the second sub-layer 107 in the visible light range is less than the extinction coefficient of the first sub-layer 106 in the visible light range. The light-emitting layer 101 includes a plurality of pixel units 102. When the thickness of the second sub-layer 107 is greater than the thickness of the first sub-layer 106, adjusting the extinction coefficient of the second sub-layer 107 in the visible light range to be less than or equal to the extinction coefficient of the first sub-layer 106 in the visible light range is beneficial for reducing the loss of light emitted by the pixel units 102 due to the second sub-layer 107 and increasing the light output efficiency of the display panel 100. The visible light range refers to a wavelength range of 380 nm to 780 nm.

In some embodiments, the extinction coefficient of the second sub-layer 107 in the visible light range is less than 0.01 and greater than or equal to 0, for example, 0.0001, 0.0002, 0.0005, 0.0008, 0.001, 0.002, 0.005, 0.006, 0.008, or the like.

In some embodiments, the extinction coefficient of the first sub-layer 106 in the visible light range is less than 0.01 and greater than or equal to 0, for example, 0.0001, 0.0002, 0.0005, 0.0008, 0.001, 0.002, 0.005, 0.006, 0.008, or the like.

In some embodiments, by controlling the difference in refractive index between the layers within the first inorganic layer 104 along the direction from the luminescent layer 101 to the packaging layer 103, including controlling the difference in refractive index between the first sub layer 106 and the second sub layer 107 to be greater than 0 and less than 0.2, it is beneficial to improvesub-layer sub-layer the light output efficiency of the display panel 100. It is to be understood that the refractive index of the present disclosure refers to a refractive index against visible light in the visible light range.

In some embodiments, the refractive index of the first sub-layer 106 is greater than 1.8, for example, 1.81, 1.82, 1.83, 1.84, 1.85, 1.88, 1.89, 1.9, 1.92, 1.95, 1.98, 2, 2.1, 2.2, 2.3, or the like.

In some embodiments, the refractive index of the second sub-layer 107 is greater than 1.7 and less than 1.95, for example, 1.71, 1.72, 1.73, 1.75, 1.76, 1.78, 1.8, 1.81, 1.82, 1.85, 1.88, 1.9, 1.92, 1.93, or the like.

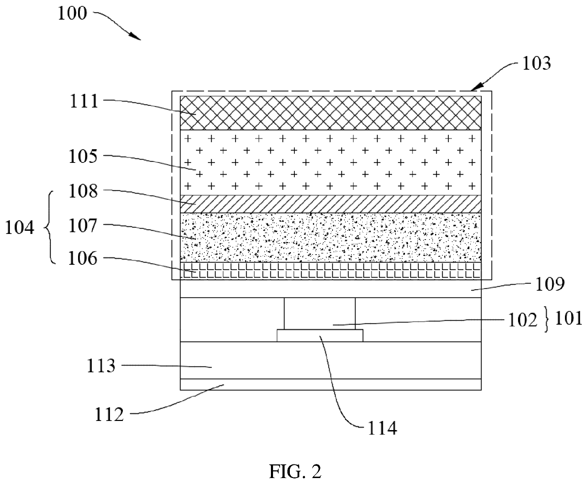

Referring to FIGs. 1 and 2, in some embodiments, the thickness of the first sub-layer 106 is less than the thickness of the second sub-layer 107.

In some embodiments, a ratio of the thickness of the second sub-layer 107 to the thickness of the first sub-layer 106 is greater than or equal to 3:1. For example, the ratio of the thickness of the second sub-layer 107 to the thickness of the first sub-layer 106 may be 4:1, 5:1, 6:1, 8:1, or the like, which is advantageous for improving the light output efficiency of the display panel 100 and alleviating the poor display due to large color difference. Further, the ratio of the thickness of the second sub-layer 107 to the thickness of the first sub-layer 106 is less than or equal to 10:1, and the thicknesses of the second sub-layer 107 and the first sub-layer 106 can be adjusted within a suitable range.

In some embodiments, when the thickness of the first sub-layer 106 is less than the thickness of the second sub-layer 107, the thickness of the first sub-layer 106 is less than or equal to 200 nanometers, for example, 20 nanometers, 50 nanometers, 80 nanometers, 120 nanometers, 140 nanometers, 150 nanometers, 180 nanometers, 190 nanometers, or the like. When the thickness of the first sub-layer is less than the thickness of the second sub-layer, the thickness of the second sub-layer 107 is greater than or equal to 600 nanometers, for example, 620 nanometers, 650 nanometers, 680 nanometers, 700 nanometers, 720 nanometers, 750 nanometers, 780 nanometers, 800 nanometers, 850 nanometers, 900 nanometers, 950 nanometers, 1000 nanometers, or the like. The first sub-layer 106 having a smaller thickness can be used to fill surface gaps on a film layer that is disposed on a side of the first sub-layer 106 close to the light-emitting layer 101 and in contact with the film layer 106, and the second sub-layer 107 having a thicker thickness is disposed on a side of the first sub-layer 106 away from the light-emitting layer 101, thereby facilitating improvement of the blocking effect of the first inorganic layer 104 on water-oxygen and improvement of the encapsulation performance of the encapsulation layer 103. Meanwhile, the extinction coefficient of the second sub-layer 107 in the visible light range is less than that of the first sub-layer 106 in the visible light range, so that the encapsulation performance of the encapsulation layer 103 is improved while the light output efficiency of the display panel 100 is increased.

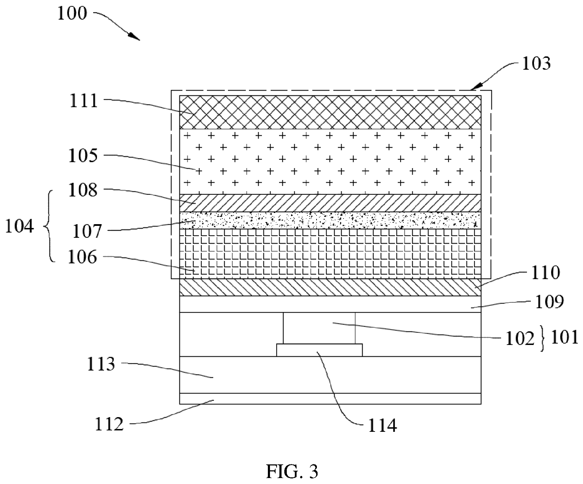

Referring to FIG. 3, in some embodiments, the thickness of the first sub-layer 106 is greater than the thickness of the second sub-layer 107.

In some embodiments, the ratio of the thickness of the first sub-layer 106 to the thickness of the second sub-layer 107 is greater than 12:1, for example, 13:1, 14:1, 15:1, 16:1, 17:1, 17.5:1, 18:1, 19:1, 20:1, 21:1, 22:1, or the like. Further, the ratio of the thickness of the first sub-layer 106 to the thickness of the second sub-layer 107 is less than or equal to 22:1, which is advantageous for improving the light output efficiency of the display panel 100 and alleviating the poor display due to large color difference.

In some embodiments, when the thickness of the first sub-layer 106 is greater than the thickness of the second sub-layer 107, the thickness of the first sub-layer 106 is greater than or equal to 600 nanometers, for example, 700 nanometers, 750 nanometers, 800 nanometers, 850 nanometers, 900 nanometers, 950 nanometers, 1000 nanometers, 1050 nanometers, 1100 nanometers, or the like. When the thickness of the first sub-layer 106 is greater than the thickness of the second sub-layer 107, the thickness of the second sub-layer 107 is greater than or equal to 50 nanometers and less than or equal to 200 nanometers, for example, 55 nanometers, 60 nanometers, 70 nanometers, 80 nanometers, 90 nanometers, 1 nanometer, 120 nanometers, 150 nanometers, 180 nanometers, 190 nanometers, or the like. The first sub-layer 106 having a larger thickness may partially fill surface gaps on a film layer that is disposed on a side of the first sub-layer 106 adjacent to the light-emitting layer 101 and in contact with the first sub-layer 106, which is beneficial for improving the blocking effect of the first inorganic layer 104 on water-oxygen, and improving the encapsulation performance of the encapsulation layer 103.

Referring to FIGs. 1 to 4, in some embodiments, the first sub-layer 106 is a layer of the first inorganic layers 104 that is closest to the light-emitting layer 101. Oxygen content of the first sub-layer 106 is less than or equal to the oxygen content of the second sub-layer 107, thereby increasing the blocking capability of the encapsulation layer 103 on water-oxygen and improving the encapsulation performance of the encapsulation layer 103.

In some embodiments, the oxygen content of the first sub-layer 106 is less than 1%, for example, 0.01%, 0.05%, 0.08%, 0.1%, 0.2%, 0.5%, 0.75%, 0.8%, 0.9%, or the like, which is beneficial for blocking water-oxygen from entering the pixel units 102, and improving the encapsulation performance of the encapsulation layer 103.

In some embodiments, a material of the first sub-layer 106 may be selected from silicon nitride compounds (for example, SiN), and a material of the second sub-layer 107 is selected from silicon nitride compounds (for example, SiN) or silicon oxynitride compounds (for example, SiNO). When the material of the second sub-layer 107 is selected from silicon oxynitride compounds, the oxygen content of the first sub-layer 106 is less than the oxygen content of the second sub-layer 107. When the material of the second sub-layer 107 is selected from the silicon nitride compounds, the oxygen content of the first sub-layer 106 may be the same as the oxygen content of the second sub-layer 107, and the oxygen content of the second sub-layer 107 may be less than 1%, thereby further increasing ability to block the entry of water-oxygen and improving the encapsulation performance of the encapsulation layer 103.

In some embodiments, the refractive indices of the film layers of the first inorganic layer 104 gradually decrease in the direction from the light-emitting layer 101 to the encapsulation layer 103. For example, referring to FIGs. 1 and 2, the first inorganic layer 104 further includes a third sub-layer 108 disposed between the second sub-layer 107 and the first organic layer 105. A refractive index of the third sub-layer 108 is less than the refractive index of the second sub-layer 107, and greater than or equal to a refractive index of the first organic layer 105. A thickness of the third sub-layer 108 is less than the thickness of the second sub-layer 107. The third sub-layer 108 is disposed such that the difference between the refractive index of the first inorganic layer 104 and the refractive index of the first organic layer 105 is gradually reduced along the direction from the light-emitting layer 101 to the encapsulation layer 103, which is beneficial for improving the light output efficiency of the display panel 100.

In some embodiments, the refractive index of the third sub-layer 108 is greater than 1.6 and less than 1.76, for example, 1.61, 1.62, 1.63, 1.64, 1.65, 1.68, 1.69, 1.7, 1.72, 1.73, 1.75, or the like.

In some embodiments, the refractive index of the first organic layer 105 is greater than 1.48 and less than 1.55, for example, 1.5, 1.51, 1.52, 1.53, 1.54, or the like.

In some embodiments, the difference between the refractive index of the third sub-layer 108 and the refractive index of the first organic layer 105 is greater than zero and less than or equal to 0.2, for example, 0.05, 0.06, 0.08, 0.1, 0.11, 0.13, 0.15, 0.16, 0.17, 0.18, 0.19, or the like.

In some embodiments, the thickness of the first organic layer 105 is greater than or equal to 8 microns and less than or equal to 13 microns, for example, 8.5 microns, 9 microns, 10 microns, 11 microns, 12 microns, or the like.

In some embodiments, an absolute value of the difference in refractive index between any two layers of the first inorganic layer 104 is greater than 0 and less than or equal to 0.25. For example, the absolute value of the difference in refractive index between any two layers of the first sub-layer 106, the second sub-layer 107, and the third sub-layer 108 is greater than 0 and less than or equal to 0.25. That is, the difference between the refractive index of the first sub-layer 106 and the refractive index of the third sub-layer 108 is greater than 0 and less than or equal to 0.25, and the difference between the refractive index of the second sub-layer 107 and the refractive index of the third sub-layer 108 is greater than 0 and less than or equal to 0.25, thereby controlling the difference in refractive index between the layers of the first inorganic layer 104 in the direction from the light-emitting layer 101 to the encapsulation layer 103, increasing the light output efficiency of the display panel 100 and alleviating the color difference caused by the fluctuation of the thicknesses of the film layers of the first inorganic layer 104 at the central area and the surrounding area of the display panel 100.

In some embodiments, the difference between the refractive index of the first sub-layer 106 and the refractive index of the second sub-layer 107 is greater than 0 and less than 0.2, for example, 0.05, 0.06, 0.07, 0.08, 0.1, 0.12, 0.13, 0.15, 0.16, 0.17, 0.18, or the like, which is beneficial for reducing the color difference caused by the fluctuation of the thicknesses of the film layers of the first inorganic layer 104 at the central area and the surrounding area of the display panel 100.

In some embodiments, the difference between the refractive index of the second sub-layer 107 and the refractive index of the third sub-layer 108 is greater than 0 and less than 0.2, for example, 0.05, 0.06, 0.07, 0.08, 0.1, 0.12, 0.13, 0.15, 0.16, 0.18, or the like, which is beneficial for reducing the color difference caused by the fluctuation of the thicknesses of the film layers of the first inorganic layer 104 at the central area and the surrounding area of the display panel 100.

Referring to Table 1, the reliability of the display panel under high-temperature and high-humidity conditions was tested by combining the first and second sub-layer s having different refractive indices with the third sub-layer 108 having a refractive index of 1.63, so as to obtain the encapsulation performances of different refractive index combinations of the first sub-layer and the second sub-layer, and the results are shown in Table 1. Here, the display panel was placed at a temperature of 85°C and a humidity of 85% (85RH) for several hours (for example, 120 hours, 240 hours, 360 hours, respectively), to evaluate whether a product defect such as dark spots occurs. In Table 1, "Pass" indicates that the display panel passes the test of the corresponding time length, and "NG" indicates that the display panel fails the test for the corresponding time length.

**Table 1. Test of Encapsulation Performance for Display Panel**

| Refractive index of the first sub-layer | Refractive index of the second sub-layer | 85°C, 85RH | | |
|---|---|---|---|---|
| | | 120 h | 240 h | 360 h |
| 1.88 | 1.81 | PASS | PASS | PASS |
| 1.88 | 1.76 | PASS | PASS | NG |
| 1.88 | 1.7 | PASS | NG | NG |
| 1.52 | 1.81 | PASS | PASS | NG |

It can be seen from Table 1 that when the refractive index of the first sub-layer is lower than that of the second sub-layer, the encapsulation performance of the display panel is poor. When the refractive index of the first sub-layer is greater than that of the second sub-layer, the encapsulation performance of the display panel increases as the difference between the refractive index of the first sub-layer and the refractive index of the second sub-layer decreases. When the difference between the refractive index of the first sub-layer and the refractive index of the second sub-layer is less than or equal to 0.12, the display panel can pass the encapsulation performance test in a relative long period, and when the difference between the refractive index of the first sub-layer and the refractive index of the second sub-layer is less than or equal to 0.07, the encapsulation performance of the display panel is significantly improved.

Referring to Table 2, where white light is displayed on the display panel and the refractive index of the first organic layer is 1.5, a simulation test of the color difference Δu' caused by a 10% difference in thickness of the first inorganic layer of the display panel (i.e., there is a large fluctuation in the thickness of the first inorganic layer) was conducted, and the results of the combination of refractive indices of the film layers of the first inorganic layer and the corresponding color difference Δu' of the resulting display panel are shown in Table 2.

**Table 2. Results of the color difference between the central area and the surrounding area of the display panel**

| [Table 1_sm_0001] | | | |
|---|---|---|---|
| Refractive index of the first sub-layer | Refractive index of the second sub-layer | Refractive index of the third sub-layer | Δu' |
| 1.88 | 1.81 | 1.76 | 0.004 |
| 1.88 | 1.81 | 1.7 | 0.0009 |
| 1.88 | 1.81 | 1.63 | 0.0007 |
| 1.88 | 1.81 | 1.52 | 0.006 |

It can be seen from Table 2 that when the refractive index of the third sub-layer is 1.52, the difference between the refractive index of the third sub-layer and the refractive index of the second sub-layer is relatively large, which causes Δu' to be large, indicating that when there is a larger fluctuation in the thickness of the first inorganic layer, the display panel shows a larger color difference and poorer chromaticity uniformity. Moreover, when the refractive index of the third sub-layer is 1.76, the difference between the refractive index of the third sub-layer and the refractive index of the first organic layer is relatively large, which also causes Δu' to be relatively large, indicating that when there is a larger fluctuation in the thickness of the first inorganic layer, the display panel shows a larger color difference and poorer chromaticity uniformity. When the refractive index of the third sub-layer is 1.7 or 1.63, the difference between the refractive index of the second sub-layer and the refractive index of the third sub-layer, and the difference between the refractive index of the third sub-layer and the refractive index of the first organic layer are all less than or equal to 0.2, and Δu' is significantly reduced, indicating that although there is a larger fluctuation in the thickness of the first inorganic layer, the color difference of the display panel is still relatively small, and the chromaticity uniformity is good.

In some embodiments, the extinction coefficient of the third sub-layer 108 in the visible light range is less than the extinction coefficient of the first sub-layer 106 in the visible light range, which is beneficial for reducing the loss of light emitted by the pixel units 102 due to the first inorganic layer 104 and increasing the light output efficiency of the display panel 100. Further, the extinction coefficient of the third sub-layer 108 in the visible light range is less than or equal to the extinction coefficient of the second sub-layer 107 in the visible light range.

In some embodiments, the extinction coefficient of the third sub-layer 108 in the visible light range is less than 0.01 and greater than or equal to 0, for example, 0, 0.0001, 0.0002, 0.0005, 0.0008, 0.001, 0.002, 0.005, 0.006, 0.008, or the like. Preferably, the extinction coefficient of the third sub-layer 108 in the visible light range may be 0, which is beneficial for minimizing the loss of light emitted from the pixel units 102 caused by the third sub-layer 108 and increasing the light output efficiency of the display panel 100.

Referring to FIGs. 1 to 4, in some embodiments, the third sub-layer 108 is a layer of the first inorganic layer 104 that is closest to the first organic layer 105, and the third sub-layer 108 is in direct contact with the first organic layer 105. The oxygen content of the second sub-layer 107 is less than or equal to the oxygen content of the third sub-layer 108. The first organic layer 105 is generally made from an organic material by an ink-jet printing technique. The oxygen content of the third sub-layer 108 is relatively high, so that the bonding force with the first organic layer 105 is improved, which reduces the possibility of peeling the first inorganic layer 104 from the first organic layer 105, and improves the product quality of the display panel 100.

In some embodiments, the oxygen content of the third sub-layer 108 is greater than or equal to 30% and less than or equal to 50%, for example, 35%, 40%, 45%, or the like, thereby facilitating adhesion between the third sub-layer 108 and the first organic layer 105.

In some embodiments, since the oxygen content of the third sub-layer 108 is relatively large, minimizing the thickness of the third sub-layer 108 is advantageous to reduce the overall thickness of the film layer having larger oxygen content within the first inorganic layer 104. Preferably, the thickness of the third sub-layer 108 is greater than or equal to 50 nanometers and less than or equal to 200 nanometers, for example, 60 nanometers, 80 nanometers, 90 nanometers, 1 nanometer, 120 nanometers, 150 nanometers, 180 nanometers, 190 nanometers, or the like.

In some embodiments, the material of the third sub-layer 108 may be selected from silicon oxynitride compounds (for example, SiNO). When the material of the second sub-layer 107 is selected from silicon nitride compounds, the oxygen content of the third sub-layer 108 is greater than the oxygen content of the second sub-layer 107. When the material of the second sub-layer 107 is selected from silicon oxynitride compounds, the oxygen content of the third sub-layer 108 may be the same as the oxygen content of the second sub-layer 107.

In some embodiments, the material of the first sub-layer 106 is the same as the material of the second sub-layer 107. Alternatively, the material of the second sub-layer 107 is the same as the material of the third sub-layer 108. The parameters in the forming processes of the film layers can be adjusted, so that the film layers made from the same material can have different refractive indices.

Referring to FIGs. 1 to 4, in some embodiments, the first inorganic layer 104 may be composed of the first sub-layer 106, the second sub-layer 107, and the third sub-layer 108. That is, one side of the second sub-layer 107 adjacent to the first sub-layer 106 is in direct contact with the first sub-layer 106, and another side of the second sub-layer 107 adjacent to the third sub-layer 108 is in direct contact with the third sub-layer 108.

In some embodiments, the first inorganic layer 104 may further include one or more layers (for example, two, three, four, or the like) between the first sub-layer 106 and the second sub-layer 107, and/or, the first inorganic layer 104 may further include one or more layers (for example, two, three, four, or the like.) between the second sub-layer 107 and the third sub-layer 108. The refractive indices of the film layers of the first inorganic layer 104 gradually decrease along the direction from the light-emitting layer 101 to the encapsulation layer 103, thereby facilitating the improvement of the light output efficiency of the display panel 100.

In some embodiments, when the first inorganic layer 104 further includes one or more layers between the first sub-layer 106 and the second sub-layer 107, and/or the first inorganic layer 104 further include one or more layers between the second sub-layer 107 and the third sub-layer 108, the absolute value of the difference in refractive index between any two layers of the first inorganic layer 104 is greater than 0 and less than or equal to 0.25, which is beneficial for controlling the difference in refractive index between the layers of the first inorganic layer 104 in the direction of the light-emitting layer 101 to the encapsulation layer 103, increasing the light output efficiency of the display panel 100, and alleviating the color difference caused by the fluctuation in the thicknesses of the film layers of the first inorganic layer 104 at the central area and the surrounding area of the display panel 100.

In some embodiments, when the first inorganic layer 104 further includes one or more layers between the first sub-layer 106 and the second sub-layer 107, the oxygen content of the one or more layers between the first sub-layer 106 and the second sub-layer 107 is greater than or equal to the oxygen content of the first sub-layer 106 and less than or equal to the oxygen content of the second sub-layer 107. Preferably, the oxygen content of the one or more layers between the first sub-layer 106 and the second sub-layer 107 is equal to the oxygen content of the first sub-layer 106.

In some embodiments, when the first inorganic layer 104 further includes one or more layers between the first sub-layer 106 and the second sub-layer 107, the material(s) of the one or more layers between the first sub-layer 106 and the second sub-layer 107 may each independently be the same as the material of the first sub-layer 106 and/or the material of the second sub-layer 107, for example, selected from silicon nitride compounds (for example, SiN) or silicon oxynitride compounds (for example, SiNO).

In some embodiments, when the first inorganic layer 104 may further include one or more layers between the second sub-layer 107 and the third sub-layer 108, the oxygen content of the one or more layers between the second sub-layer 107 and the third sub-layer 108 is greater than or equal to the oxygen content of the second sub-layer 107, and less than or equal to the oxygen content of the third sub-layer 108.

In some embodiments, when the first inorganic layer 104 may further include one or more layers between the second sub-layer 107 and the third sub-layer 108, the material(s) of the one or more layers between the second sub-layer 107 and the third sub-layer 108 may each independently be the same as the material of the second sub-layer 107 and/or the material of the third sub-layer 108, for example, selected from silicon nitride compounds (for example, SiN) or silicon oxynitride compounds (for example, SiNO).

Referring to FIGs. 1 to 4, in some embodiments, the display panel 100 includes a cathode layer 109 disposed between the light-emitting layer 101 and the encapsulation layer 103.

Referring to FIGs. 1, 3, and 4, in some embodiments, the display panel 100 includes a light extraction layer 110 disposed between the cathode layer 109 and the encapsulation layer 103. The material of the light extraction layer 110 may be an organic material or an inorganic material for improving the light emission performance from the pixel units 102. When the display panel 100 includes the light extraction layer 110, the first sub-layer 106 is in direct contact with the light extraction layer 110, and the first sub-layer 106 covers a side of the light extraction layer 110 away from the light-emitting layer 101, thereby improving the encapsulation performance of the encapsulation layer 103.

In some embodiments, the refractive index of the light extraction layer 110 is greater than or equal to the refractive index of the first sub-layer 106. The refractive index of the light extraction layer 110 is greater than or equal to 1.8 and less than or equal to 2.2, for example, 1.95, 2, 2.05, 2.1, 2.15, or the like.

In some embodiments, the difference between the refractive index of the light extraction layer 110 and the refractive index of the first sub-layer 106 is greater than 0 and less than 0.2, for example, 0.02, 0.05, 0.06, 0.08, 0.1, 0.12, 0.15, 0.16, 0.18, or the like, which is beneficial for reducing the difference in the refractive index between the respective film layers in the direction from the light-emitting layer 101 to the encapsulation layer 103 and improving the light output efficiency of the display panel 100.

Referring to FIG. 1, in some embodiments, when the thickness of the first sub-layer is less than the thickness of the second sub-layer, and the display panel 100 includes the light extraction layer 110, a side of the first sub-layer 106 close to the light extraction layer 110 is in contact with the light extraction layer 110, and the thickness of the first sub-layer 106 may be less than 200 nanometers, for example, 1 nanometer, 120 nanometers, 150 nanometers, 160 nanometers, 180 nanometers, 190 nanometers, or the like, which is beneficial for filling the surface gap of the light extraction layer 110 through the material of the first sub-layer 106, thereby further increasing the ability of blocking the entering of water-oxygen, and improving the encapsulation performance of the encapsulation layer 103.

In some embodiments, when the thickness of the first sub-layer is less than the thickness of the second sub-layer, and the display panel 100 includes the light extraction layer 110, the thickness of the light extraction layer 110 is greater than or equal to 60 nanometers and less than or equal to 100 nanometers, for example, 65 nanometers, 70 nanometers, 75 nanometers, 80 nanometers, 85 nanometers, 90 nanometers, 95 nanometers, or the like.

In some embodiments, when the thickness of the first sub-layer is less than the thickness of the second sub-layer, and the display panel 100 includes the light extraction layer 110, the refractive index of the first sub-layer 106 is close to the refractive index of the light extraction layer 110, and the thickness of the light extraction layer 110 may be appropriately reduced and the reduction value in the thickness of the light extraction layer 110 may be complemented by the thickness of the first sub-layer 106. Specifically, the sum of the thicknesses of the light extraction layer 110 and the first sub-layer 106 is greater than or equal to 60 nanometers and less than or equal to 100 nanometers, for example, 65 nanometers, 70 nanometers, 75 nanometers, 80 nanometers, 85 nanometers, 90 nanometers, 95 nanometers, or the like. When the sum of the thicknesses of the light extraction layer 110 and the first sub-layer 106 is greater than or equal to 60 nanometers and less than or equal to 100 nanometers, the ratio of the thickness of the light extraction layer 110 to the thickness of the first sub-layer 106 may be adjusted according to the light emission performance of the pixel units 102. The ratio of the thickness of the light extraction layer 110 to the thickness of the first sub-layer 106 may be greater than or equal to 1:10 and less than or equal to 10:1, for example, 1:9, 1:8, 1:7, 1:6, 1:5, 1:4, 1:3, 1:2, 1:1, 2:1, 3:1, 4:1, 5:1, 6:1, 7:1, 8:1, 9:1, or the like.

Referring to FIG. 2, in some embodiments, when the thickness of the first sub-layer is less than the thickness of the second sub-layer, and the display panel 100 includes the light extraction layer 110, the refractive index of the first sub-layer 106 is close to the refractive index of the light extraction layer 110, and the light extraction layer may be replaced by the first sub-layer 106. That is, the display panel 100 may not include a light extraction layer, and a side of the first sub-layer 106 close to the cathode layer 109 is in contact with the cathode layer 109, thereby facilitating reduction of the production cost of the display panel 100. To this end, the thickness of the first sub-layer 106 may be less than or equal to 100 nanometers, for example, 20 nanometers, 40 nanometers, 50 nanometers, 60 nanometers, 70 nanometers, 80 nanometers, 90 nanometers, or the like. Further, when the light extraction layer is replaced by the first sub-layer 106, the thickness of the first sub-layer 106 may be equivalent to the thickness of the original light extraction layer. That is, the thickness of the first sub-layer 106 may be greater than or equal to 60 nanometers.

In some embodiments, when the light extraction layer is replaced by the first sub-layer 106, and a side of the first sub-layer 106 close to the cathode layer 109 is in contact with the cathode layer 109, the refractive index of the first sub-layer 106 is greater than the refractive index of the cathode layer 109, which is beneficial for increasing the light output efficiency of the display panel 100.

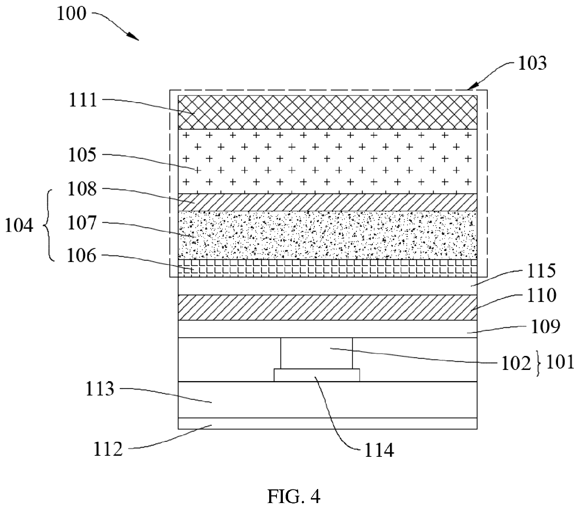

In some embodiments, when the thickness of the first sub-layer 106 is greater than the thickness of the second sub-layer 107, or the thickness of the first sub-layer 106 is less than the thickness of the second sub-layer 107, the display panel 100 includes the cathode layer 109 between the light-emitting layer 101 and the encapsulation layer 103, the light extraction layer 110 between the cathode layer 109 and the encapsulation layer 103, and an adjustment layer 115 between the light extraction layer 110 and the encapsulation layer 103, as shown in FIG. 4. The refractive index of the adjustment layer 115 is less than the refractive index of the light extraction layer 110, and the refractive index of the adjustment layer 115 is less than the refractive index of the first sub-layer 106. The refractive index of the adjustment layer 115 is set between the refractive index of the light extraction layer 110 and the refractive index of the first sub-layer 106, so that the light extraction layer 110 having a higher refractive index is advantageously used as a convex lens to enhance the light concentrating effect, so as to improve the light output efficiency and display quality of the display panel 100.

In some embodiments, the refractive index of the light extraction layer 110 is greater than the refractive index of the first sub-layer 106, and the refractive index of the first sub-layer 106 is greater than the refractive index of the adjustment layer 115.

In some embodiments, the refractive index of the adjustment layer 115 is less than 1.6, for example, 1.3, 1.33, 1.35, 1.37, 1.4, 1.43, 1.45, 1.47, 1.48, 1.5, 1.53, 1.55, 1.58, or the like.

Referring to FIG. 4, in some embodiments, one side of the adjustment layer 115 close to the first sub-layer 106 is in contact with the first sub-layer 106, and another side of the adjustment layer 115 close to the light extraction layer 110 is in contact with the light extraction layer 110.

In some embodiments, the thickness of the adjustment layer 115 is less than 100 nanometers, for example, 10 nanometers, 15 nanometers, 20 nanometers, 25 nanometers, 30 nanometers, 35 nanometers, 40 nanometers, 50 nanometers, 60 nanometers, 70 nanometers, 80 nanometers, 90 nanometers, or the like, in order to adjust the light concentrating effect of the light extraction layer 110 within a suitable thickness range of the adjustment layer 115 and improve the display quality of the display panel 100.

In some embodiments, the material of the adjustment layer 115 may be selected from a material having a refractive index between the refractive index of the first sub-layer 106 and the refractive index of the light extraction layer 110. For example, the material of the adjustment layer 115 may include lithium fluoride (LiF).

Referring to FIGs. 1 to 4, in some embodiments, the encapsulation layer 103 includes a second inorganic layer 111 disposed on a side of the first organic layer 105 away from the first inorganic layer 104. The extinction coefficient of the second inorganic layer 111 in the visible light range is less than 0.01, for example, 0.0001, 0.0002, 0.0005, 0.0008, 0.001, 0.002, 0.005, 0.006, 0.008, and the like. Further, the extinction coefficient of the second inorganic layer 111 in the visible light range is greater than or equal to 0, which is beneficial for reducing the loss of light emitted by the second inorganic layer 111 to the pixel units 102 and increasing the light output efficiency of the display panel 100.

In some embodiments, the second inorganic layer 111 has a refractive index greater than 1.8, for example, 1.81, 1.82, 1.85, 1.86, 1.87, 1.9, 1.91, 1.92, or the like.

In some embodiments, the second inorganic layer 111 includes a fourth sub-layer. A material of the fourth sub-layer may be selected from silicon nitride compounds (for example, SiN).

In some embodiments, the thickness of the second inorganic layer 111 is greater than or equal to 500 nanometers and less than or equal to 900 nanometers, for example, 550 nanometers, 600 nanometers, 650 nanometers, 700 nanometers, 750 nanometers, 800 nanometers, 850 nanometers, or the like.

Referring to FIGs. 1 to 4, in some embodiments, the display panel 100 further includes a substrate 112 disposed on a side of the light-emitting layer 101 away from the encapsulation layer 103. The substrate 112 may be a hard substrate, such as a glass substrate. Alternatively, the substrate 112 may be a flexible substrate, such as a polyimide-based substrate. When the substrate 112 is a flexible substrate, the substrate 112 may be formed by a plurality of sub-substrates of the same material, such as polyimide, by bonding any two adjacent layers of these sub-substrates using adhesive sub-layer s.

Referring to FIGs. 1 to 4, in some embodiments, the display panel 100 further includes a thin film transistor layer 113 disposed between the substrate 112 and the light-emitting layer 101. The thin film transistor layer 113 includes a thin film transistor. The thin film transistor includes a semiconductor disposed on the substrate 112. The semiconductor may be formed from polysilicon or a metal oxide such as indium gallium zinc oxide. The semiconductor is divided into a channel area, and source and drain areas formed on both sides of the channel area. The thin film transistor layer 113 further includes a first gate insulating layer. The first gate insulating layer covers the semiconductor. The thin film transistor further includes a first gate formed on the first gate insulating layer. The first gate overlaps the channel area. The first gate may be formed from a plurality of layers or a single layer comprising a low resistance material such as Al, Ti, Mo, Cu, Ni, or an alloy thereof, or a material with high corrosion resistance. The thin film transistor layer 113 includes a second gate insulating layer. The second gate insulating layer covers the first gate. The thin film transistor further includes a second gate disposed on the second gate insulating layer first gate. The second gate overlaps the first gate. The second gate may be formed from a plurality of layers or a single layer comprising a low resistance material such as Al, Ti, Mo, Cu, Ni, or an alloy thereof, or a material with high corrosion resistance. The thin film transistor layer 113 includes a first interlayer insulating layer disposed on the second gate. The first interlayer insulating layer, the first gate insulating layer, and the second gate insulating layer include a source contact hole and a drain contact hole, and the source area and the drain area are exposed through the source contact hole and the drain contact hole, respectively.

The thin film transistor further includes a source and a drain disposed in the same layer, both formed on the first interlayer insulating layer. The source is connected to the source area through the source contact hole, and the drain is connected to the drain area through the drain contact hole. The source and the drain may be formed from a plurality of layers or a single layer comprising a low-resistance material such as Al, Ti, Mo, Cu, Ni, or an alloy thereof, or a material with high corrosion resistance. For example, the source and the drain may be a triple layer structures, such as Ti/Cu/Ti, Ti/Ag/Ti, Ti/Al/Ti or Mo/Al/Mo, or other single or multi-layer structure.

In some embodiments, the display panel 100 further includes a flattening layer between the thin film transistor layer 113 and the light-emitting layer 101. The flattening layer covers the source and drain.

Referring to FIGs. 1 to 4, in some embodiments, the display panel 100 further includes an anode layer disposed between the flattening layer and the light-emitting layer 101. The anode layer includes a plurality of anodes 114 disposed in one-to-one correspondence with the pixel units 102. Each of the anodes 114 is electrically connected to the thin film transistor. The flattening layer includes an anode contact hole through which the anode 114 contacts the source or drain of the thin film transistor.

In some embodiments, the display panel 100 further includes a pixel definition layer disposed on the same side of the substrate 112 as the pixel units 102. The pixel definition layer includes pixel definition portions and openings between the pixel definition portions, and the pixel units 102 are disposed within the openings. The openings expose a portion of the anode 114 and cover an edge of the anode 114. The pixel units 102 may include a red pixel unit, a green pixel unit, and a blue pixel unit.

Referring to FIGs. 1 to 4, in some embodiments, the cathode layer 109 covers the light-emitting layer 101. In the direction from the anode 114 to the cathode layer 109, the light-emitting layer 101 includes a hole organic layer, a light-emitting material layer, and an electron organic layer, which are sequentially laminated. The hole organic layer may include a hole injection layer and a hole transport layer. The hole injection layer is in direct contact with the anode 114, and the hole transport layer is between the hole injection layer and the light-emitting material layer. The hole organic layer may further include an electron-blocking layer between the hole transport layer and the light-emitting material layer. The electron organic layer may include an electron injection layer in direct contact with the cathode layer 109 and an electron transport layer between the electron injection layer and the light-emitting material layer. The electron organic layer may include a hole blocking layer between the electron transport layer and the light-emitting layer 101.

In some embodiments, the display panel 100 further includes a touch layer disposed on a side of the encapsulation layer 103 away from the light-emitting layer 101. The touch layer can realize self-capacitance touch or mutual-capacitance touch. When the touch layer implements a self- capacitance touch, the touch layer may include only one touch metal layer.

When the touch layer realizes a mutual-capacitance touch, the touch layer includes a first touch metal layer, a touch insulating layer, and a second touch metal layer. The touch insulating layer is disposed on a side of the first touch metal layer away from the encapsulation layer 103, and the second touch metal layer is disposed on a side of the touch insulating layer away from the encapsulation layer 103. The first touch metal layer may be disposed directly on the encapsulation layer 103. Alternatively, a spacer layer may be disposed between the first touch layer and the encapsulation layer 103. The spacer layer may include an inorganic spacer layer and/or an organic spacer layer. The first touch metal layer includes a first touch electrode, a second touch electrode, and a first bridge connection wire. The second touch metal layer includes a second bridge connection wire. Both the first touch electrode and the second touch electrode are metal networks. Alternatively, the second touch metal layer includes a first touch electrode, a second touch electrode, and a first bridge connection wire, and the first touch metal layer includes a second bridge connection wire.

In some embodiments, the display panel 100 includes a polarizing layer disposed on a side of the touch layer away from the encapsulation layer 103.

In some embodiments, the display panel 100 includes a cover layer that may be bonded to the polarizing layer by an optical adhesive layer.

According to the display panel 100 in the embodiments of the present disclosure, the first sub-layer 106 and the second sub-layer 107 are provided in the first inorganic layer 104 of the encapsulation layer 103, the refractive indices of the first sub-layer 106 and the second sub-layer 107 are sequentially reduced, and the thickness of the second sub-layer 107 is larger than that of the first sub-layer 106, so that the light output efficiency of the display panel 100 is increased, and the display effect of the display panel 100 is improved.

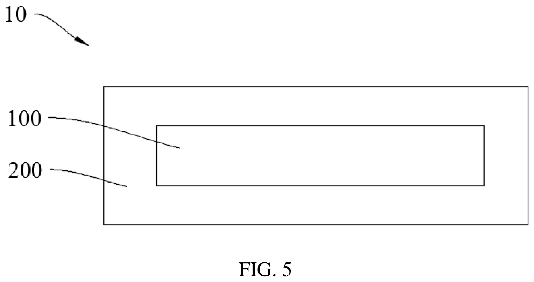

Referring to FIG. 5, an embodiment of the present disclosure further provides a display device 10 including the display panel 100 as described above.

The specific structure of the display panel 100 is described in any one of the above embodiments and the accompanying drawings with regard to the display panel, and will not be repeated herein.

In some embodiments, the display device 10 includes a device body 200 that is integrated with the display panel 100.

In some embodiments, the device body 200 may include a middle frame and a frame glue. The display device 10 may be a display terminal includes, but not limited to, a mobile phone, a tablet, and a television.

Embodiments of the present disclosure disclose a display panel and a display device comprising the display panel. The display panel includes the light-emitting layer and the encapsulation layer. The light-emitting layer includes the plurality of pixel units. The encapsulation layer is disposed on the light exiting side of the light-emitting layer, and includes the first inorganic layer and the first organic layer. The first organic layer is disposed on a side of the first inorganic layer away from the light-emitting layer. The first inorganic layer includes the first sub-layer and the second sub-layer, and the second sub-layer is disposed between the first sub-layer and the first organic layer. The refractive index of the first sub-layer is greater than the refractive index of the second sub-layer, and the thickness of the first sub-layer is less than the thickness of the second sub-layer. By providing the first sub-layer and the second sub-layer in the first inorganic layer in the encapsulation layer of the display panel and setting the refractive indices of the first sub-layer and the second sub-layer to be decreased sequentially and the thickness of the first sub-layer being less than the thickness of the second sub-layer, the light output efficacy of the display panel is increased, and the display effect of the display panel is improved.

It is to be understood for the ordinary skill in the art that equivalent substitutions or changes may be made in accordance with the technical solutions of the present disclosure and its inventive concept, and all such changes or substitutions shall fall within the scope of the claims appended to the present disclosure.

## Claims

1. A display panel, comprising:
a light-emitting layer; and
an encapsulation layer disposed on a light-output side of the light-emitting layer, the encapsulation layer comprising a first inorganic layer and a first organic layer, the first organic layer being disposed on a side of the first inorganic layer away from the light-emitting layer;
wherein the first inorganic layer comprises a first sub-layer and a second sub-layer, the second sub-layer is disposed between the first sub-layer and the first organic layer, and a refractive index of the first sub-layer is greater than a refractive index of the second sub-layer; and
a thickness of the first sub-layer is less than a thickness of the second sub-layer.

2. The display panel according to claim 1, wherein an extinction coefficient of the second sub-layer in a visible light region is less than or equal to an extinction coefficient of the first sub-layer in the visible light region.

3. The display panel according to claim 1, wherein a ratio of the thickness of the second sub-layer to the thickness of the first sub-layer is greater than or equal to 3:1.

4. The display panel according to claim 3, wherein the thickness of the second sub-layer is greater than or equal to 600 nanometers.

5. The display panel according to claim 1, further comprising a cathode layer disposed between the light-emitting layer and the encapsulation layer, wherein a side of the first sub-layer close to the cathode layer is in contact with the cathode layer, and the thickness of the first sub-layer is less than or equal to 100 nanometers.

6. The display panel according to claim 1, further comprising a cathode layer disposed between the light-emitting layer and the encapsulation layer, and a light extraction layer disposed between the cathode layer and the encapsulation layer, wherein a side of the first sub-layer close to the light extraction layer is in contact with the light extraction layer, and the thickness of the first sub-layer is less than or equal to 200 nanometers.

7. The display panel according to claim 6, wherein a sum of a thickness of the light extraction layer and the thickness of the first sub-layer is greater than or equal to 60 nanometers and less than or equal to 100 nanometers.

8. The display panel according to claim 1, further comprising a cathode layer disposed between the light-emitting layer and the encapsulation layer, a light extraction layer disposed between the cathode layer and the encapsulation layer, and an adjustment layer disposed between the light extraction layer and the encapsulation layer;
wherein a refractive index of the adjustment layer is less than a refractive index of the light extraction layer, and the refractive index of the adjustment layer is less than the refractive index of the first sub-layer.

9. The display panel according to claim 8, wherein the refractive index of the adjustment layer is less than 1.6.

10. The display panel according to claim 1, wherein the first inorganic layer further comprises a third sub-layer disposed between the second sub-layer and the first organic layer, a refractive index of the third sub-layer is less than the refractive index of the second sub-layer and greater than or equal to a refractive index of the first organic layer, and a thickness of the third sub-layer is less than the thickness of the second sub-layer.

11. The display panel according to claim 10, wherein an extinction coefficient of the third sub-layer in the visible light region is less than the extinction coefficient of the first sub-layer in the visible light region.

12. The display panel according to claim 10, wherein a difference between the refractive index of the first sub-layer and the refractive index of the second sub-layer is greater than 0 and less than 0.2; and
a difference between the refractive index of the second sub-layer and the refractive index of the third sub-layer is greater than 0 and less than 0.2.

13. The display panel according to claim 12, wherein the refractive index of the first sub-layer is greater than 1.8;
the refractive index of the second sub-layer is greater than 1.7 and less than 1.95; and
the refractive index of the third sub-layer is greater than 1.6 and less than 1.76.

14. The display panel according to claim 12, wherein a difference between the refractive index of the first sub-layer and the refractive index of the third sub-layer is greater than 0 and less than or equal to 0.25.

15. The display panel according to claim 10, wherein an oxygen element content of the first sub-layer is less than or equal to an oxygen element content of the second sub-layer, and the oxygen element content of the second sub-layer is less than or equal to an oxygen element content of the third sub-layer.

16. The display panel according to claim 15, wherein the oxygen element content of the first sub-layer is less than 1%.

17. The display panel according to claim 16, wherein the oxygen element content of the second sub-layer is less than 1%.

18. The display panel according to claim 16, wherein a material of the first sub-layer is selected from a silicon nitride compound, a material of the second sub-layer is selected from a silicon nitride compound or a silicon oxynitride compound, and a material of the third sub-layer is selected from a silicon oxynitride compound.

19. The display panel according to claim 1, wherein the encapsulation layer further comprises a second inorganic layer disposed on a side of the first organic layer away from the first inorganic layer;
wherein an extinction coefficient of the second inorganic layer in the visible light region is less than 0.01.

20. A display device, comprising a display panel, the display panel comprising:
a light-emitting layer; and
an encapsulation layer disposed on a light-output side of the light-emitting layer, the encapsulation layer comprising a first inorganic layer and a first organic layer, the first organic layer being disposed on a side of the first inorganic layer away from the light-emitting layer;
wherein the first inorganic layer comprises a first sub-layer and a second sub-layer, the second sub-layer is disposed between the first sub-layer and the first organic layer, and a refractive index of the first sub-layer is greater than a refractive index of the second sub-layer; and
a thickness of the first sub-layer is less than a thickness of the second sub-layer.
